(19) Europäisches Patentamt
European Patent Office
Office européen des brevets

(11) **EP 3 560 099 B1**

(12) **EUROPÄISCHE PATENTSCHRIFT**

(45) Veröffentlichungstag und Bekanntmachung des Hinweises auf die Patenterteilung:
**08.07.2020   Patentblatt 2020/28**

(21) Anmeldenummer: **17825478.5**

(22) Anmeldetag: **15.12.2017**

(51) Int Cl.:
*H02S 50/00* (2014.01)     *H02J 3/38* (2006.01)

(86) Internationale Anmeldenummer:
**PCT/EP2017/083146**

(87) Internationale Veröffentlichungsnummer:
**WO 2018/114716 (28.06.2018 Gazette 2018/26)**

(54) **SCHALTUNG ZUR SPANNUNGSBEGRENZUNG IN EINEM PHOTOVOLTAIKFELD, PHOTOVOLTAIKFELD UND VERFAHREN ZUR SPANNUNGSBEGRENZUNG**

CIRCUIT FOR VOLTAGE LIMITATION IN A PHOTOVOLTAIC FIELD, PHOTOVOLTAIC FIELD AND METHOD FOR VOLTAGE LIMITATION

CIRCUIT DE LIMITATION DE LA TENSION DANS UN GROUPE PHOTOVOLTAÏQUE, GROUPE PHOTOVOLTAÏQUE ET PROCÉDÉ DE LIMITATION DE LA TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.12.2016   DE 102016125219**

(43) Veröffentlichungstag der Anmeldung:
**30.10.2019   Patentblatt 2019/44**

(73) Patentinhaber: **SMA Solar Technology AG**
**34266 Niestetal (DE)**

(72) Erfinder:
• **NESEMANN, Karl**
  **34260 Kaufungen (DE)**
• **FALK, Andreas**
  **34131 Kassel (DE)**

(56) Entgegenhaltungen:
**EP-A1- 2 362 520          WO-A1-2015/183840**
**WO-A2-2015/092441     DE-A1-102009 044 695**
**DE-A1-102010 009 120     DE-T5-112014 006 170**
**JP-A- S6 017 516          US-A1- 2013 049 710**
**US-A1- 2013 076 144**

EP 3 560 099 B1

**Beschreibung**

Die Erfindung betrifft eine Schaltung zur Spannungsbegrenzung eines photovoltaischen Strings, ein Photovoltaikfeld mit einer Mehrzahl von parallelen Strings, die eine solche Schaltung aufweisen, sowie ein Verfahren zur Spannungsbegrenzung eines photovoltaischen Strings.

Um große photovoltaische Energieerzeugungsanlagen wirtschaftlich gestalten zu können, ist es wünschenswert, möglichst viele Solarmodule in Reihe zu schalten, sodass diese Reihenschaltung, ein sogenannter String, eine sehr hohe Spannung aufweist. Um den zulässigen Eingangsspannungsbereich eines angeschlossenen Wechselrichters oder die zulässige Modulspannung gegenüber Erdpotenzial nicht zu überschreiten, muss man die Länge eines solchen Strings so begrenzen, dass dessen Leerlaufspannung auch bei extremen Bedingungen, insbesondere bei niedrigen Temperaturen und hoher Einstrahlung, den maximal zulässigen Wert nicht überschreitet.

Es ist alternativ aus dem Stand der Technik bekannt, Schaltungen vorzusehen, die bei Überschreiten einer maximalen Stringspannung einen Teil der Module abtrennt oder kurzschließt, um eine Spannungsreduzierung zu erreichen. Nachdem die Stringspannung wieder ausreichend abgesunken ist, kann der Kurzschluss beziehungsweise die Abtrennung wieder aufgehoben werden. Ein Beispiel für eine solche Schaltung ist in der Schrift US 2013/0049710 A1 offenbart, in der zur Spannungsbegrenzung zwei oder mehr Solarmodule eines Strings mittels eines Relais überbrückt werden, wenn ein Leerlaufzustand des Strings festgestellt wird. Alternativ offenbart die Schrift EP 2 362 520 A1, einen Teil der Module in diesem Fall abzutrennen.

Weiterhin offenbart beispielsweise die Schrift DE 10 2010 009 120 A1 ein Photovoltaikfeld von parallelen Strings, wobei ein Teil der parallelen Strings gemeinsam über einen Kurzschlussschalter kurzschließbar sind, dessen Aktivierung bei Überschreitung einer vorgegebenen Spannung durch den String erfolgt. Da das Kurzschließen eines Teils eines Strings eine Leistungseinbuße für die Energieerzeugungsanlagen darstellt, ist es wünschenswert, die Strings einzeln verkürzen zu können, um nur die in der vorliegenden Situation erforderliche Anzahl an Strings verkürzen zu müssen. Hierbei muss allerdings sichergestellt sein, dass die verkürzten Strings nicht durch die langen Strings in eine Rückstromsituation gebracht werden, in der in den kurzen Strings ein den Nennstrom des Strings erheblich überschreitender Strombetrag in Rückwärtsrichtung fließt und diesen Strings schädigen kann.

Es ist daher Aufgabe dieser Erfindung, eine Schaltung beziehungsweise ein Verfahren zur Spannungsbegrenzung eines Strings bereitzustellen, die jeweils in der Lage sind, bei Überschreiten eines Schwellwerts durch die Stringspannung den String zu verkürzen, wobei der Schwellwert von der Schaltung so ermittelt wird, dass schädigende Rückstromsituationen vermieden werden. Es ist weiterhin Aufgabe dieser Erfindung, ein Photovoltaikfeld mit einer Mehrzahl von parallelen Strings mit jeweils einer solchen Schaltung aufzuzeigen, wobei die Schaltungen der einzelnen Strings unabhängig voneinander arbeiten.

Diese Aufgabe wird gelöst durch eine Schaltung des unabhängigen Anspruchs 1 beziehungsweise durch Photovoltaikfeld des nebengeordneten Anspruchs 6. Weiterhin wird diese Aufgabe gelöst durch ein Verfahren gemäß des unabhängigen Anspruchs 12. Bevorzugte Ausführungsformen sind in den abhängigen Ansprüchen beschrieben.

Eine erfindungsgemäße Schaltung zur Spanungsbegrenzung eines photovoltaische Strings, der in einen ersten Abschnitt und einen zweiten Abschnitt einer Reihenschaltung von Solarmodulen aufgeteilt ist, umfasst einen ersten Anschluss zur Verbindung mit einem ersten Ende des ersten Abschnitts, einen zweiten Anschluss zur Verbindung mit einem ersten Ende des zweiten Abschnitts und einem dritten Anschluss zur Verbindung mit einem zweiten Ende des zweiten Abschnitts, sowie einen Überbrückungsschalter, der mit einem Ende mit dem ersten Anschluss und dem anderen Ende mit dem dritten Anschluss verbunden ist und einen Trennschalter, der mit einem Ende mit dem ersten Anschluss und dem anderen Ende mit dem zweiten Anschluss verbunden ist. Eine Steuerung der Schaltung dient zur Ansteuerung des Überbrückungsschalters und des Trennschalters, wobei die Steuerung dazu eingerichtet ist, einen ersten Schwellwert $U_{UL}$ und einen zweiten, kleineren Schwellwert $U_{LL}$ in Abhängigkeit von einer über den Trennschalter in einem geöffneten Zustand abfallenden Schalterspannung $U_{OC}$ und unter Berücksichtigung der Anzahl der Solarmodule im ersten Abschnitt und im zweiten Abschnitt zu ermitteln, und eine zwischen dem ersten Anschluss und einem Spannungseingang der Schaltung abfallenden Modulspannung $U_S$ mit den Schwellwerten $U_{UL}$, $U_{LL}$ zu vergleichen, um bei Überschreiten des ersten Schwellwertes $U_{UL}$ durch die Modulspannung $U_S$ den Trennschalter zu öffnen und den Überbrückungsschalter zu schließen, und bei Unterschreiten des zweiten Schwellwertes $U_{LL}$ durch die Spannung $U_S$ den Überbrückungsschalter zu öffnen und den Trennschalter zu schließen.

Durch die erfindungsgemäße Schaltung können die Abschnitte in Abhängigkeit der Modulspannung $U_S$ so elektrisch miteinander verbunden oder getrennt werden, dass bei hinreichend niedriger Modulspannung und damit einer hieraus ermittelbaren Stringspannung der erste Abschnitt und der zweite Abschnitt in Reihe geschaltet werden können - im Folgenden als langer Zustand des Strings bezeichnet -, während bei einer so hohen Modulspannung, dass eine Reihenschaltung der Abschnitte zu einer unerwünscht hohen Stringspannung führen würde, der zweite Abschnitt abgetrennt und überbrückt wird und so nicht zur Stringspannung beiträgt - im Folgenden als kurzer Zustand des Strings bezeichnet. Auf diese Weise gewährleistet die Schaltung eine Begrenzung der Stringspannung, ohne die durch den String maximal erreichbare Leistung zu reduzieren. Die Schaltung kann hierbei auch in bestehende Strings nachträglich integriert werden, da der String hierzu lediglich in einen ersten und einen zweiten Abschnitt aufgeteilt und die Anschlüsse der Schaltung mit entsprechenden Anschlusspunkten des Strings verbunden werden müssen.

Vorteilhaft ist die Schaltung zur Energieversorgung aus der Modulspannung $U_S$ eingerichtet und so nicht auf eine eigene Energiequelle angewiesen. Hierzu entnimmt die Schaltung die zum Betrieb erforderliche Energie der zwischen dem ersten Anschluss und dem Spannungseingang anliegenden Spannung. Gegebenenfalls ist ein Energiespeicher, beispielsweise einen Kondensator, Superkondensator oder eine aufladbare Batterie, vorgesehen, um die Schaltung auch in Zeiten zu versorgen, in denen die anliegende Modulspannung $U_S$ nicht ausreicht.

Der Trennschalter und der Überbrückungsschalter werden bevorzugt als Halbleiterschalter, insbesondere als Feldeffekttransistor oder Bipolartransistor, noch genauer als IGBT oder MOSFET, vorgesehen und können gleichen oder unterschiedlichen Typs sein. Eine intrinsische oder eine separate antiparallele Freilaufdiode können mit den Schaltern vorgesehen sein.

Aufgrund der vorgesehenen Verbindung der Anschlüsse der Schaltung entspricht die über den geöffneten Trennschalter abfallende Spannung der Leerlaufspannung des zweiten Abschnitts, sofern der Überbrückungsschalter geschlossen ist oder aufgrund einer dem Überbrückungsschalter zugeordneten Freilaufdiode keine nennenswerte Spannung am Überbrückungsschalter abfällt. Somit erlaubt die Messung der über den geöffneten Trennschalter abfallenden Spannung eine Bestimmung der Leerlaufspannung der Solarmodule beziehungsweise des Strings. Aus dieser Kenntnis kann direkt abgeleitet werden, ob und gegebenenfalls inwieweit die Stringspannung eine Leerlaufspannung des ersten Abschnitts übersteigt, so dass ein Rückstrom entstehen kann, wenn der zweite Abschnitt vom ersten Abschnitt getrennt beziehungsweise überbrückt wird. Entsprechend kann der zweite Schwellwert $U_{LL}$ so gewählt werden, dass Rückströme vermieden oder zumindest auf ein ungefährliches Maß begrenzt werden.

An dieser Stelle sei darauf hingewiesen, dass für die Ermittlung geeigneter Schwellwerte $U_{UL}$, $U_{LL}$ die Kenntnis der Anzahl der Solarmodule im ersten Abschnitt und der Anzahl der Solarmodule im zweiten Abschnitt, sowie der Anzahl der Solarmodule, über die die Modulspannung $U_S$ bestimmt wird, in der Steuerung hinterlegt sein müssen. Die Werte können als absolute oder als relative Werte hinterlegt sein. Mit Kenntnis dieser Werte kann die Modulspannung $U_S$ direkt in eine über den ersten Abschnitt abfallende Spannung beziehungsweise in eine Stringspannung umgerechnet werden.

Wenn der Trennschalter geschlossen ist und die Leerlaufspannung des zweiten Abschnitts als eine über den Trennschalter abfallende Spannung nicht bestimmbar ist, ist es vorteilhaft, in der Steuerung eine Bedingung vorzusehen, dessen Erfüllung kontinuierlich oder regelmäßig geprüft wird. Die Bedingung beschreibt eine Notwendigkeit, die Leerlaufspannung des zweiten Abschnitts dahingehend zu prüfen, ob eine Änderung derselben stattgefunden hat und eine Aktualisierung der Schwellwerte $U_{UL}$, $U_{LL}$ durchzuführen. Bei einer Erfüllung der Bedingung bei geschlossenem Trennschalter führt die Steuerung eine Aktualisierung der Schwellwerte $U_{UL}$, $U_{LL}$ durch, indem der Trennschalter kurzzeitig geöffnet und die über den geöffneten Trennschalter abfallende Schalterspannung $U_{OC}$ bestimmt wird. Aus der bestimmten Schalterspannung werden die aktualisierten Schwellwerte ermittelt. Die Bedingung kann einen Ablauf einer vorgegebenen Zeitdauer seit dem letzten Schließen des Trennschalters aufweisen. Alternativ oder zusätzlich kann die Bedingung auch eine Überschreitung eines vorgegebenen Änderungsschwellwertes durch die Differenz der Modulspannung $U_S$ zwischen dem aktuellen Wert und dem direkt nach dem letzten Schließen des Trennschalters bestimmten Wert aufweisen. Auch eine Bedingung, die von einer Temperaturänderung der Solarmodule seit dem letzten Schließen des Trennschalters abhängt, ist denkbar.

In einem weiteren Aspekt umfasst ein Photovoltaikfeld eine Mehrzahl von zwischen einem ersten und einem zweiten Gleichspannungsbus parallel geschalteten Strings, die jeweils einen ersten Abschnitt und einen zweiten Abschnitt von Reihenschaltungen von Solarmodul aufweisen. Der erste und der zweite Abschnitt sind über eine vorstehend beschriebene erfindungsgemäße Schaltung miteinander verbunden, wobei jeweils ein Ende des ersten Abschnitts mit dem ersten Gleichspannungsbus und das andere Ende des ersten Abschnitts mit dem ersten Anschluss der Schaltung verbunden ist. Gleichzeitig ist ein Ende des zweiten Abschnitts mit dem zweiten Anschluss der Schaltung verbunden und das andere Ende des zweiten Abschnitts mit dem zweiten Gleichspannungsbus. Der dritte Anschluss der Schaltung ist ebenfalls mit dem anderen Ende des zweiten Abschnitts verbunden, während der Spannungseingang mit einem dem ersten Anschluss der Schaltung abgewandten Anschluss eines Solarmoduls des ersten Abschnitts verbunden ist, so dass zwischen dem ersten Anschluss der Schaltung und dem Spannungseingang die Spannung eines Teils des ersten Abschnitts oder des gesamten ersten Abschnitts abfällt und als Modulspannung $U_S$ bestimmbar ist. Um die Modulspannung gering zu halten, kann bevorzugt der Spannungseingang mit dem Anschluss desjenigen Solarmoduls des ersten Abschnitts verbunden sein, das mit dem anderen Anschluss direkt mit dem ersten Anschluss der Schaltung verbunden ist. Auf diese Weise entspricht die Modulspannung $U_S$ der Spannung eines Solarmoduls.

Um das Photovoltaikfeld optimal auf den Eingangsspannungsbereich eines angeschlossenen Wechselrichters anzupassen, kann die Anzahl der Solarmodule des ersten Abschnitts derart gewählt sein, dass bei einer niedrigsten spezifizierten Umgebungstemperatur und einer höchsten spezifizierten Einstrahlung deren Leerlaufspannung noch unter einem vorgegebenen Maximalwert verbleibt, und die Anzahl der Solarmodule des zweiten Abschnitts derart gewählt sein, dass unter den gleichen spezifizierten Extrembedingungen eine MPP-Spannung der Reihenschaltung des ersten und zweiten Abschnitts noch unter dem vorgegebenen Maximalwert verbleibt. Der Maximalwert entspricht in diesem Fall der maximalen Eingangsspannung des Wechselrichters beziehungsweise der spezifizierten Maximalspannung einer Komponente des Photovoltaikfeldes, zum Beispiel der maximalen Isolationsspannung der Solarmodule. Hierdurch kann erreicht werden, dass der Wechselrichter auch bei den spezifizierten Extrembedingungen im Leerlaufzustand mit dem Photovoltaikfeld verbunden bleiben kann. Bevorzugt ist der Maximalwert größer als 1000 Volt, insbesondere 1500 Volt und entspricht so gängigen Spezifikationen von handelsüblichen Wechselrichtern für Freiflächenanlagen.

Das andere Ende des zweiten Abschnitts kann direkt mit dem zweiten Gleichspannungsbus verbunden sein. Es kann aber auch ein dritter Abschnitt von Solarmodulen zwischen dem anderen Ende und dem Gleichspannungsbus angeordnet sein, sodass der überbrückbare zweite Abschnitt zwischen zwei nicht überbrückbaren Abschnitten angeordnet ist. Ein solcher dritter Abschnitt von Solarmodulen wird bei der Bestimmung der Anzahl der Solarmodule des ersten Abschnitts mit berücksichtigt, sodass im Folgenden auf die Anzahl der Solarmodule im dritten Abschnitt nicht mehr explizit Bezug genommen wird, weil diese im ersten Abschnitt mitgezählt werden.

Es kann in einem Photovoltaikfeld mit mehreren parallelen Strings, die durch die erfindungsgemäße Schaltung spannungsbegrenzt werden, vorteilhaft sein, sicherzustellen, dass ein Wechsel der Strings zwischen dem langen und dem kurzen Zustand möglichst nicht zeitgleich erfolgt. Dies trägt zu einem spannungsstabilen Betrieb des Photovoltaikfeldes bei. Dies kann erreicht werden, indem in den Schaltungen der parallelen Strings jeweils ein von den anderen String unterschiedlicher Offset hinterlegt ist, der bewirkt, dass die Steuerungen der Schaltungen bei gleicher bestimmter Schalterspannung $U_{OC}$ unterschiedliche Schwellwerte $U_{UL}$, $U_{LL}$ ermitteln. Somit werden in der Regel in den verschiedenen Schaltungen der Strings voneinander unterschiedliche Schwellwerte auch dann ermittelt, wenn die Temperatur- und Einstrahlungsbedingungen zwischen den Strings gleich sind. Entsprechend werden unterschiedliche Zeitpunkte des Wechselns zwischen langem und kurzem Zustand des Strings erreicht.

Ein erfindungsgemäßes Verfahren zur Spannungsbegrenzung eines photovoltaischen Strings, der einen ersten Abschnitt und einen zweiten Abschnitt von Solarmodulen aufweist, wobei ein Überbrückungsschalter parallel zum zweiten Abschnitt angeordnet ist und ein Trennschalter in Reihe zu den Solarmodulen des zweiten Abschnitts angeordnet ist, umfasst ein wiederholtes Bestimmen einer Modulspannung $U_S$ innerhalb des ersten Abschnitts und einer über den Trennschalter abfallenden Schalterspannung $U_{OC}$, während der Trennschalter geöffnet und der Überbrückungsschalter geschlossen ist. In Abhängigkeit der Schalterspannung $U_{OC}$ und unter Berücksichtigung einer Anzahl der Solarmodule im ersten Abschnitt und im zweiten Abschnitt wird ein erster Schwellwert $U_{UL}$ und ein zweiter, kleinerer Schwellwert $U_{LL}$ bestimmt. Zur Herstellung eines kurzen Zustands des Strings wird der Überbrückungsschalter geschlossen und der Trennschalter geöffnet, wenn die aktuell bestimmte Modulspannung $U_S$ den ersten Schwellwert $U_{UL}$ überschreitet. Zur Herstellung eines langen Zustands des Strings wird der Überbrückungsschalter geöffnet und der Trennschalter geschlossen, wenn die aktuell bestimmte Modulspannung $U_S$ den zweiten Schwellwert $U_{LL}$ unterschreitet. Auf diese Weise kann der String eigenständig rechtzeitig in den kurzen Zustand wechseln, um eine überhöhte Stringspannung zu vermeiden, und wieder in den langen Zustand wechseln, wenn die Stringspannung ausreichend abgesunken ist. Insbesondere kommt das Verfahren ohne Kommunikation, zum Beispiel mit einer übergeordneten Steuereinrichtung, aus.

Die Schwellwerte werden hierbei nicht fest vorgegeben, sondern flexibel den herrschenden Betriebsbedingungen, beispielsweise der herrschenden Temperatur und Einstrahlung, angepasst. Die Anpassung erfordert hierbei nicht einmal entsprechende Sensoren, da die bestimmten Spannungen bereits ausreichend Information über die herrschenden Bedingungen enthalten. Dennoch soll die Einbeziehung weiterer Sensordaten, zum Beispiel eines Temperatur- oder eines Einstrahlungssensors oder eines Stromsensors zur Bestimmung des Stringstroms, nicht ausgeschlossen werden, da diese Einbeziehung das Verfahren weiter verbessern kann. Es soll auch nicht ausgeschlossen werden, dass an anderen Strings bestimmte Spannungswerte, insbesondere dort bei einer parallelen Ausführung des erfindungsgemäßen Verfahrens gewonnene Spannungswerte, bei der Bestimmung der Schwellwerte berücksichtigt werden, obwohl hierdurch der Vorteil der Eigenständigkeit des Zustandswechsels eingeschränkt wird.

Beim Wechsel vom langen Zustand in den kurzen Zustand wird bevorzugt zunächst der Trennschalter geöffnet, bevor der Überbrückungsschalter geschlossen wird. Analog wird beim Wechsel vom kurzen Zustand in den langen Zustand zunächst der

Überbrückungsschalter geöffnet, und dann der Trennschalter geschlossen. Weiterhin sollte sichergestellt sein, dass der Trennschalter eine ausreichende Zeit geöffnet war, bevor die an ihm abfallende Spannung bestimmt wird, damit die so bestimmte Spannung auch die Leerlaufspannung des zweiten Abschnitts darstellt. So wird in einem Ausführungsbeispiel der Erfindung der zwischen dem Schalten des Trennschalters und dem Schalten des Überbrückungsschalters eine Wartezeit von 1 µs vorgesehen. Nach dem Öffnen des Trennschalters kann in einem weiteren Ausführungsbeispiel eine Wartezeit zwischen 200 µs und 10 ms vorgesehen werden, bevor die über den Trennschalter abfallende Spannung bestimmt wird.

Wenn der String eine lange Zeit im langen Zustand verbleibt, kann es sinnvoll sein, eine Neukalibrierung der Schwellwerte durchzuführen, um den Zeitpunkt des Wechsels in den kurzen Zustand optimal zu treffen. Hierzu wird eine Bedingung zur Neukalibrierung geprüft, während der String sich im langen Zustand befindet. Bei Erfüllung der Bedingung wechselt die Schalterstellung kurzzeitig in den kurzen Zustand, um die über den Trennschalter abfallende Schalterspannung $U_{OC}$ zu bestimmen und daraus aktualisierte Schwellwerte $U_{UL}$, $U_{LL}$ zu ermitteln. Bevorzugt wird gleichzeitig eine aktualisierte Modulspannung $U_S$ ermittelt und mit dem aktualisierten Schwellwert $U_{UL}$ verglichen. Liegt die aktualisierte Modulspannung $U_S$ unterhalb des aktualisierten Schwellwerts $U_{UL}$, wird zurück in den langen Zustand gewechselt, andernfalls verbleibt der String im kurzen Zustand.

Die Bedingung zur Neukalibrierung kann den Ablauf einer Wartezeit umfassen, In der der String in einem langen Zustand war. In einem Ausführungsbeispiel wird eine Wartezeit zwischen 100 Sekunden und 30 Minuten verwendet. Die Wartezeit sollte so gewählt werden, dass sich die herrschenden Betriebsbedingungen während dieser Zeit nicht maßgeblich ändern.

In einer Variante des Verfahrens umfasst die Bedingung für die Neukalibrierung eine Überschreitung eines vorgegebenen Änderungsschwellwertes durch die Differenz der Modulspannung $U_S$ zwischen dem aktuellen Wert und dem Wert direkt nach dem letzten Wechsel in den langen Zustand. So kann durch die Überschreitung des Änderungsschwellwerts eine maßgebliche Änderung der herrschenden Betriebsbedingungen detektiert werden. Natürlich ist es denkbar, mehrere Teilbedingungen, beispielsweise die beiden vorstehend beschriebenen Bedingungsbeispiele, durch logische Verknüpfung zu der Bedingung für die Neukalibrierung zu verknüpfen.

In einer Ausführungsform des erfindungsgemäßen Verfahrens wird zunächst der erste Schwellwert $U_{UL}$ ermittelt, zum Beispiel indem ein funktionaler Zusammenhang zwischen der Modulspannung $U_S$ und/oder der über den Trennschalter abfallenden Spannung $U_{OC}$ als Funktionsparameter und dem ersten Schwellwert $U_{UL}=f(U_S, U_{OC})$ zugrunde gelegt wird. Ebenfalls denkbar ist es, den ersten Schwellwert $U_{UL}$ mittels einer Wertetabelle, gegebenenfalls mit Interpolation zwischen den Werten der Wertetabelle, zu ermitteln. Der zweite Schwellwert kann grundsätzlich über einen zweiten funktionalen Zusammenhang oder eine zweite Wertetabelle in analoger Weise ermittelt werden. Besonders vorteilhaft ist es aber, den zweiten Schwellwert $U_{LL}$ nur aus dem bereits ermittelten ersten Schwellwert $U_{UL}$ zu bestimmen. Auch dieser Ermittlung kann ein dritter funktionaler Zusammenhang $U_{LL}=g(U_{UL})$ oder eine dritte Wertetabelle zugrunde gelegt werden.

Um unerwünscht große oder kleine Schwellwerte zu vermeiden, können jeweils zulässige Wertebereiche für den ersten Schwellwert $U_{UL}$ und den zweiten Schwellwert $U_{LL}$ vorgegeben werden, wobei beim Verlassen des jeweiligen zulässigen Wertebereichs der Schwellwert auf den jeweiligen Grenzwert des Wertebereichs festgelegt wird.

Im Folgenden wird die Erfindung mithilfe von Figuren dargestellt, von denen

Fig. 1     eine erfindungsgemäße Schaltung zur Spannungsbegrenzung eines Strings,

Fig. 2     ein erfindungsgemäßes Photovoltaikfeld mit parallelen Strings, die eine spannungsbegrenzende Schaltung aufweisen,

Fig. 2a     ein weiteres erfindungsgemäßes Photovoltaikfeld mit parallelen Strings, die eine spannungsbegrenzende Schaltung aufweisen

Fig. 3     ein Ablaufdiagramm für ein erfindungsgemäßes Verfahren zur Spannungsbegrenzung von Strings, sowie

Fig. 4     einen Strom-Spannungs-Kennlinienverlauf eines erfindungsgemäßen Photovoltaikfeldes zeigt.

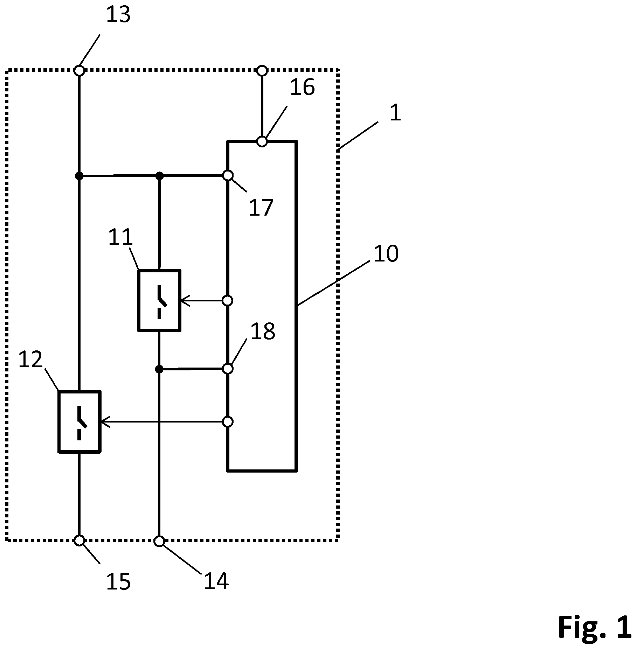

Fig. 1 zeigt den Aufbau einer Schaltung 1 zur Verbindung mit Abschnitten eines photovoltaische Strings. Ein erster Anschluss 13 der Schaltung 1, an dem ein Ende eines ersten Abschnitts eines photovoltaische Strings anschließbar ist, ist über einen Trennschalter 11 mit einem zweiten Anschluss 14 der Schaltung 1 verbunden, an dem ein Ende eines zweiten Abschnitts des Strings anschließbar ist. Auf diese Weise kann über den Trennschalter 11 eine elektrische Verbindung zwischen dem ersten Abschnitt und dem zweiten Abschnitt gesteuert werden.

Gleichzeitig ist der erster Anschluss 13 über einen Überbrückungsschalter 12 mit einem dritten Anschluss 15 der Schaltung 1 verbunden, der mit dem anderen Ende des zweiten Abschnitts des Strings verbindbar ist. Auf diese Weise kann über den Überbrückungsschalter 12 der zweite Abschnitt gesteuert überbrückt werden, so dass ein durch den ersten Abschnitt fließender Strom um den zweiten Abschnitt herum geleitet wird. Auf diese Weise kann erreicht werden, dass der String derart angesteuert werden kann, dass er in einer Schalterstellung des Trennschalters 11 und des Überbrückungsschalters 12 eine Länge hat, die der Länge des ersten Abschnitts entspricht, und in einer weiteren Schalterstellung eine Länge hat, die der Summe der Längen des ersten und des zweiten Abschnitts entspricht.

Eine Steuerung 10 kann den Trennschalter 11 und den Überbrückungsschalter 12 über entsprechende Steuerleitungen zur Veränderung der Stringlänge einschalten beziehungsweise ausschalten. Zur Erzeugung der Einschaltbeziehungsweise Ausschaltsignale verfügt die Steuerung 10 über einen ersten Spannungseingang 17 und einen zweiten Spannungseingang 18, über die eine über den Trennschalter 11 abfallende Schalterspannung $U_{OC}$ bestimmt werden kann. Im gezeigten Fall ist der erste Spannungseingang 17 mit dem ersten Anschluss 13 und der zweite Spannungsanschluss 18 mit dem zweiten Anschluss 14 verbunden. Alternativ denkbar kann der zweite Spannungseingang 18 auch mit dem dritten Anschluss 15 verbunden sein und so die über den Trennschalter 11 und den Überbrückungsschalter 12 gemeinsam abfallende Spannung bestimmen.

Bei Anschluss der Stringabschnitte wie oben beschrieben fällt die Leerlaufspannung des zweiten Abschnitts über den Trennschalter 11 ab, wenn dieser geöffnet ist. Weiterhin ist die Steuerung 10 mit einem dritten Spannungseingang 16 verbunden, der mit einem Verbindungspunkt zwischen Solarmodulen des ersten Abschnitts verbunden ist, sodass zwischen dem dritten Spannungseingang 16 und dem ersten Spannungseingang 17 eine Modulspannung $U_S$ des ersten Abschnitts des Strings abfällt und bestimmbar ist. Bevorzugt wird der dritte Spannungseingang 16 mit dem dem ersten Anschluss 13 abgewandten Ende des direkt mit der Schaltung 1 verbundenen Solarmoduls des ersten Abschnitts des Strings verbunden, sodass die Modulspannung $U_S$ die aktuelle Spannung dieses Solarmoduls darstellt. Es ist natürlich alternativ auch denkbar, den dritten Spannungseingang 16 mit einer anderen Stelle der Reihenschaltung der Solarmodule des ersten Abschnitts 21 zu verbinden, um so die Spannung über mehrere Solarmodule oder sogar über den ganzen ersten Abschnitt 21 auf diese Weise zu bestimmen.

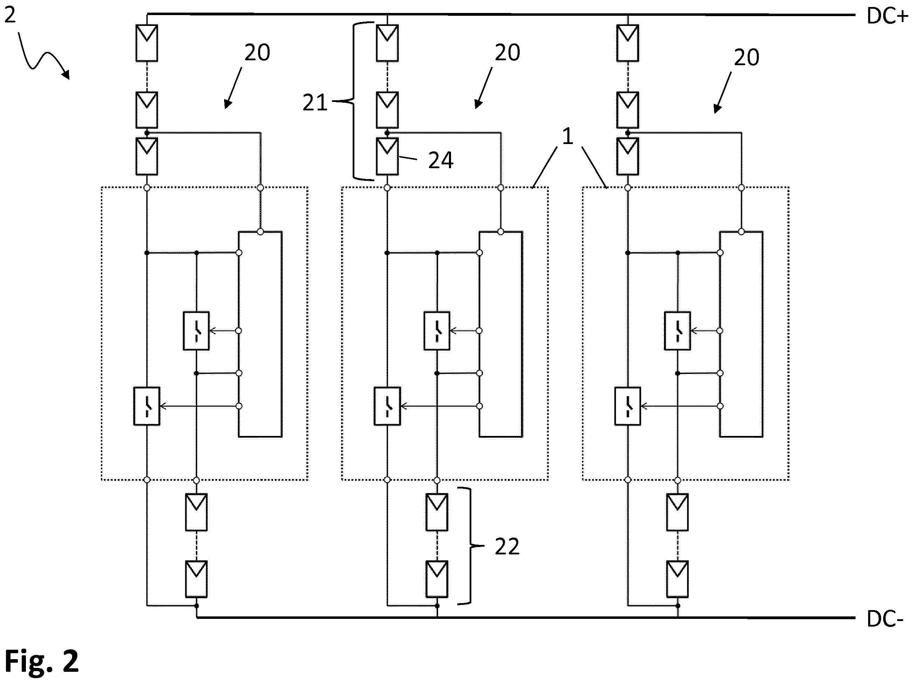

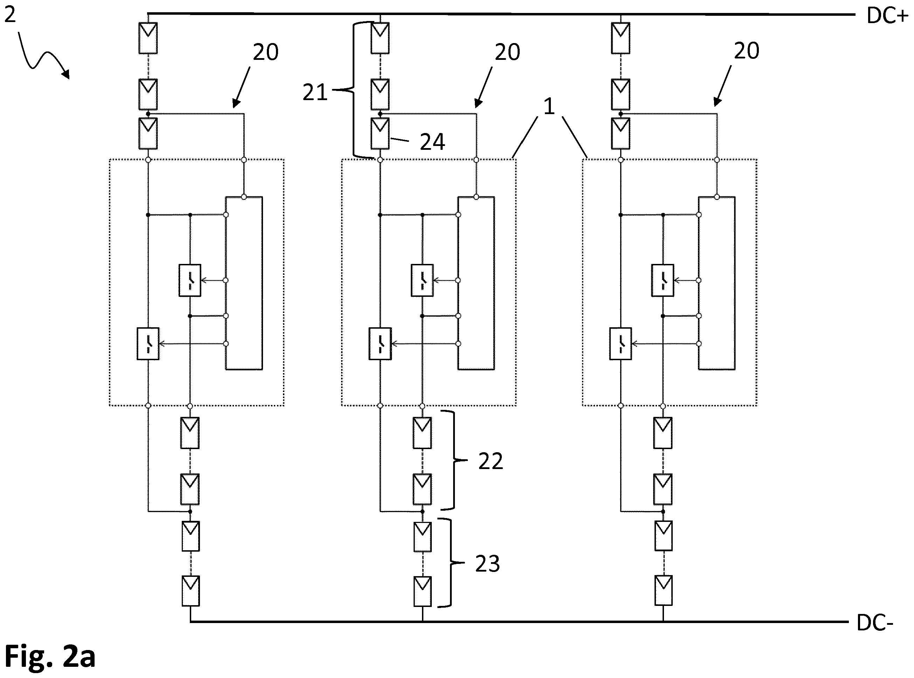

Fig. 2 zeigt ein Photovoltaikfeld 2 mit einer Mehrzahl parallel geschalteter Strings 20, die jeweils eine erfindungsgemäße Schaltung 1 aufweisen. Ein erster Abschnitt 21 einer Reihenschaltung von Solarmodulen des Strings 20 ist mit einem Ende an den ersten Anschluss 13 der Schaltung 1 und mit einem anderen Ende an einen positiven Gleichstrombus DC+ angeschlossen. Der dritte Spannungseingang 16 der Schaltung 1 ist an ein dem ersten Anschluss 13 abgewandtes Ende eines Solarmoduls 24 angeschlossen, damit die Schaltung 1 die Modulspannung am Solarmodul 24 bestimmen kann. Am zweiten Anschluss 14 der Schaltung 1 ist ein Ende eines zweiten Abschnitts 22 einer Reihenschaltung von Solarmodulen des Strings 20 angeschlossen, während das andere Ende mit einem negativen Gleichstrombus DC- verbunden ist. Mit dem negativen Gleichstrombus DC- ist auch der dritte Anschluss 15 der Schaltung 1 verbunden.

Das Photovoltaikfeld 2 aus Fig. 2a unterscheidet sich von dem aus Fig. 2 dadurch, dass ein dritter, nicht überbrückbarer Abschnitts 23 von Solarmodulen vorgesehen ist, der zwischen dem zweiten Abschnitt 22 und dem negativen Gleichstrombus DC- angeordnet ist. Auch in dieser Anordnung kann die Schaltung 1 zur Spannungsbegrenzung eingesetzt werden.

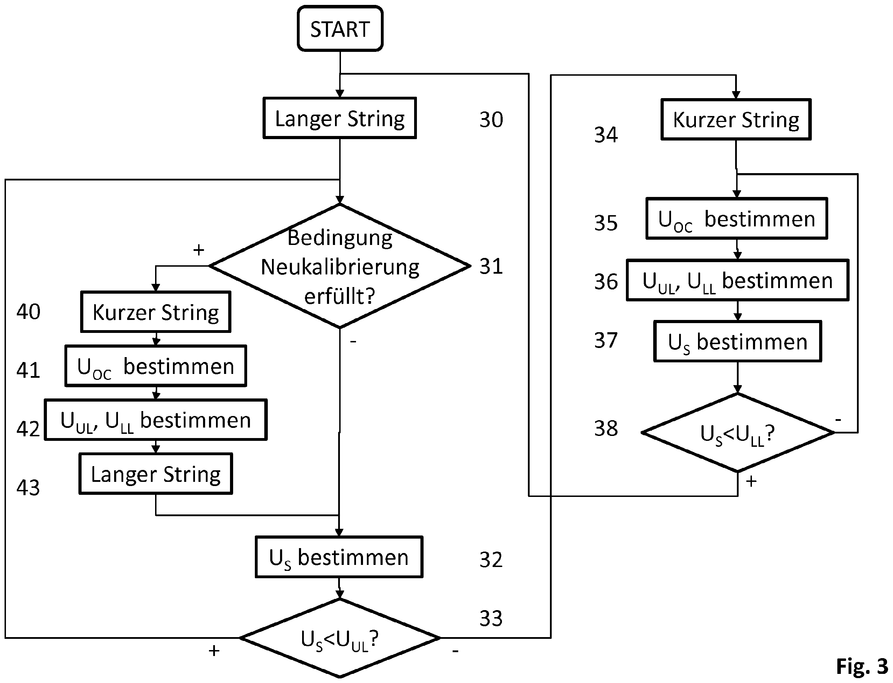

Ein Ablaufdiagramm für ein erfindungsgemäßes Verfahren zur Spannungsreduktion eines photovoltaische Strings ist in Fig. 3 gezeigt. Zu Beginn des Verfahrens befindet sich entsprechend Schritt 30 der String in einem langen Zustand, das heißt der erste Abschnitt und der zweite Abschnitt sind in Reihe miteinander verbunden. Falls erforderlich, wird der String durch Öffnen des Überbrückungsschalters 12 und Schließen des Trennschalters 11 in einen langen Zustand versetzt. In diesem Zustand wird in einem Schritt 31 geprüft, ob eine Bedingung für eine Neukalibrierung der Schwellwerte erfüllt ist. Auf diese Bedingung und die Schritte, die bei Erfüllung der Bedingung unternommen werden, wird in einem späteren Abschnitt der Beschreibung noch einmal Bezug genommen. Anschließend wird in Schritt 32 die Modulspannung $U_S$ bestimmt, wobei gegebenenfalls hochfrequente Anteile durch Mittelwertbildung mehrerer Messungen oder Tiefpass-Filterung aus dem Messergebnis entfernt werden. Auch wenn die Modulspannung $U_S$ nur an einem Teil des ersten Abschnitts oder sogar nur an einem einzelnen Solarmodul des ersten Abschnitts bestimmt wird, wird der Einfachheit der Darstellung halber davon ausgegangen, dass sich die Modulspannung $U_S$ im Folgenden auf die Gesamtspannung des ersten Abschnitts bezieht. Gegebenenfalls wird der bestimmte Wert mit einem geeigneten Skalierungsfaktor versehen, der die Anzahl der Solarmodule im ersten und zweiten Abschnitt berücksichtigt. Der bestimmte Wert der Modulspannung $U_S$ wird im Schritt 33 mit dem aktuellen ersten Schwellwert $U_{UL}$ verglichen. Ist die Modulspannung $U_S$ kleiner als der erste Schwellwert $U_{UL}$, wird zum Schritt 31 zurückgekehrt.

Übersteigt die Modulspannung $U_S$ allerdings den ersten Schwellwert $U_{UL}$, wird in einem Schritt 34 ein kurzer Zustand des Strings hergestellt, indem der Überbrückungsschalter geschlossen und der Trennschalter geöffnet wird. Anschließend wird in einem Schritt 35 die über den Trennschalter abfallende Schalterspannung $U_{OC}$ bestimmt, die ein Maß für die Leerlaufspannung der Solarmodule ist und im Wesentlichen mit der Leerlaufspannung des zweiten Abschnitts übereinstimmt. Aus der so bestimmten Schalterspannung $U_{OC}$ wird in einem Schritt 36 dann ein aktueller erster Schwellwert $U_{UL}$ und ein zweiter, kleinerer Schwellwert $U_{LL}$ ermittelt. Bei dieser Ermittlung wird die Anzahl der Solarmodule des ersten Abschnitts und des zweiten Abschnitts mit berücksichtigt.

In einem Ausführungsbeispiel für die Ermittlung der Schwellwerte werden die folgenden Formeln verwendet:

$$U_{UL} = f_1(U_{OC}) * \frac{n+m}{m}; \quad U_{LL} = f_2(U_{OC}) * \frac{n}{m}$$

Hierbei ist n die Anzahl der Solarmodule im ersten Abschnitt und m die Anzahl der Solarmodule im zweiten Abschnitt. Die Funktionen $f_1$ und $f_2$ können beispielsweise über eine Lookup-Tabelle definiert werden. Es ist aber auch denkbar, eine oder beide Funktionen $f_1$, $f_2$ als lineare Funktionen der Leerlaufspannung $U_{OC}$ vorzusehen. Unabhängig davon sollte die Funktion $f_1$ derart ausgelegt werden, dass der Schwellwert $U_{UL}$ möglichst hoch, aber noch so gering ausfällt, dass der erste Abschnitt des Strings durch die anliegende Spannung bei der Überführung in den kurzen Zustand nicht einem schädlich hohen Rückstrom ausgesetzt wird. Vorteilhafterweise wird der Schwellwert $U_{UL}$ so gewählt, dass kein Rückstrom auftritt oder sichergestellt ist, dass der Rückstrom kleiner als der Nennstrom des Solarmoduls bleibt. Weiterhin wird empfohlen, obere und/oder untere Grenzwerte für die Schwellwerte $U_{UL}$, $U_{LL}$ vorzusehen, die einen Wertebereich definieren, den die Schwellwerte nicht verlassen sollen.

Falls es gewünscht ist, dass die Schaltungen zur Spannungsbegrenzung in parallelen Strings auch unter identischen Temperatur- und Einstrahlungsbedingungen zwischen den Strings nicht zum gleichen Zeitpunkt schalten, ist es von Vorteil, einen Offset-Wert vorzusehen, der zwischen den parallelen Strings unterschiedlich gewählt, beispielsweise als Zufallszahl bestimmt wird. Dieser Offsetwert kann auf die nach der obigen Formel bestimmten Schwellwerte aufaddiert werden.

Zur weiteren Beschreibung des erfindungsgemäßen Verfahrens zurückkehrend wird in einem Schritt 37 nach der Ermittlung der aktualisierten Schwellwerte $U_{UL}$, $U_{LL}$ erneut die Modulspannung $U_S$ bestimmt, wobei sich die bestimmte Modulspannung nunmehr lediglich auf die Spannung des ersten Abschnitts des Strings bezieht. Die so bestimmte Modulspannung $U_S$ wird mit den zweiten Schwellwert $U_{LL}$ verglichen. Übersteigt die Modulspannung $U_S$ den zweiten Schwellwert $U_{LL}$, wird zu Schritt 35 zurückgekehrt und der String verbleibt im kurzen Zustand. Andernfalls wird zu Schritt 30 verzweigt und der String wird wieder in einen langen Zustand versetzt.

Da die Leerlaufspannung als über dem Trennschalter abfallende Schalterspannung $U_{OC}$ in einem langen Zustand des Strings nicht bestimmt werden kann, wird im vorstehend beschriebenen Schritt 31 geprüft, ob eine Bedingung zur Neukalibrierung der Schwellwerte erfüllt ist. Diese Bedingung kann den Ablauf eines Zeitgebers seit der letzten Ermittlung aktualisierter Schwellwerte umfassen. Die Bedingung kann aber auch ein Änderungskriterium für die Modulspannung umfassen. Beispielsweise kann geprüft werden, ob sich die aktuelle Modulspannung gegenüber der bestimmten Modulspannung beim letzten Wechsel in den langen Zustand um einen vorgegebenen Prozentsatz oder einen vorgegebenen Absolutbetrag geändert hat. Selbstverständlich ist auch eine logische Verknüpfung mehrerer Bedingungen, insbesondere eine ODER-Verknüpfung, denkbar.

Sofern die Bedingung in Schritt 31 erfüllt ist, wird der String in einem Schritt 40 in den kurzen Zustand versetzt, so dass in Schritt 41 die über dem Trennschalter abfallende Schalterspannung $U_{OC}$ bestimmt und hieraus in einem Schritt 42 aktuelle Schwellwerte $U_{UL}$, $U_{LL}$ ermittelt werden. Hiernach wird der String in einem Schritt 43 wieder umgehend in den langen Zustand versetzt und das Verfahren an Schritt 32 fortgesetzt. Schritt 40 kann in analoger Weise zu Schritt 34, der Schritt 41 analog zu Schritt 35, der Schritt 42 analog zu Schritt 36 und Schritt 43 analog zu Schritt 30 ausgeführt werden.

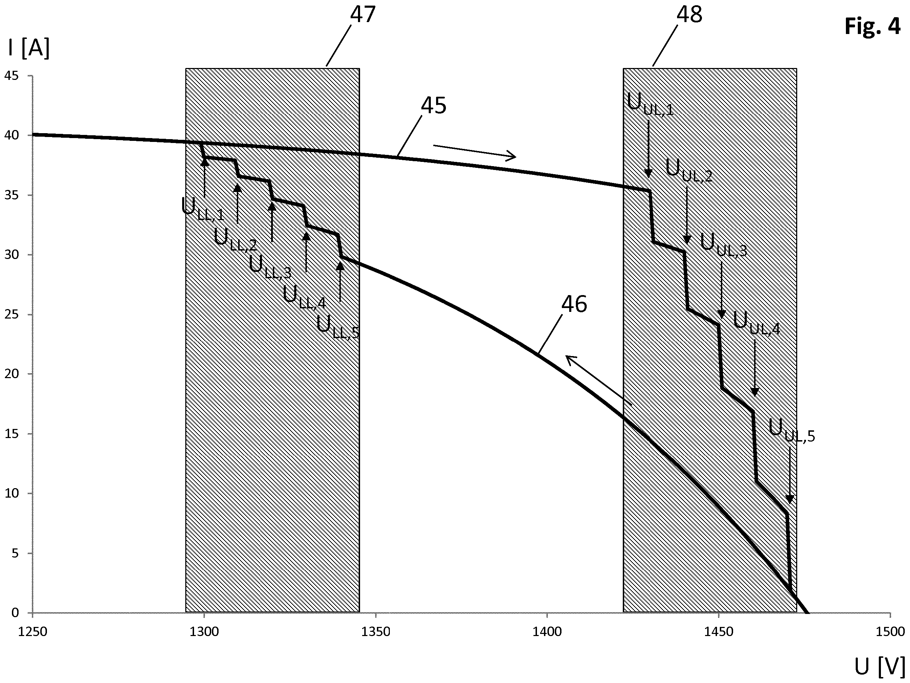

Eine beispielhafte Kennlinie eines Photovoltaikfelds mit fünf parallelgeschalteten Strings, die jeweils eine erfindungsgemäße Schaltung zur Spannungsbegrenzung aufweisen, ist in Fig. 4 gezeigt und veranschaulicht gleichzeitig die Wirkungsweise des erfindungsgemäßen Verfahrens. Auf der horizontalen Achse ist die Spannung der parallel geschalteten Strings gezeigt, auf der vertikalen Achse die Summe der Stringströme. Die Kennlinie bezieht sich auf eine String-Konfiguration von 32 Solarmodulen im ersten Abschnitt und 4 Solarmodulen im zweiten Abschnitt, jeweils mit einer Leerlaufspannung von 46,1 V und einem Kurzschlussstrom von 8,33 A. Eine Einstrahlung von 1000W/m$^2$ und eine Zelltemperatur von 10°C wurden zugrunde gelegt. Dies ergibt eine MPP-Leistung des Strings von 9927 W bei einer MPP-Spannung von 1296 V.

Bei einer geringen Stringspannung als Ausgangsspannung, hier kleiner 1300 V, sind alle Strings des Photovoltaikfeldes in einem langen Zustand. Mit steigender Spannung nimmt die gezeigte Kennlinie einen oberen Verlauf 45 bis zu einer Spannung $U_{UL,1}$ von 1430 V. Bei dieser Spannung wird der erste String in einen kurzen Zustand überführt, wodurch sich eine negative Stromstufe ergibt. Bei weiter steigender Spannung wird alle 10 V (siehe Stromsprünge bei den Spannungswerten $U_{UL,2...5}$) jeweils ein weiterer String in den kurzen Zustand überführt, bis bei einer Spannung oberhalb 1470 V alle Strings sich in dem kurzen Zustand befinden. Somit ist sichergestellt, dass das Photovoltaikfeld auch im Leerlauf eine Spannung von 1475 V nicht übersteigt, so dass ein Wechselrichter mit einer zulässigen maximalen Eingangsspannung von 1500 V auch in diesem Fall gefahrlos mit dem Photovoltaikfeld verbunden bleiben kann, obwohl die Leerlaufspannung aller Solarmodule des ersten und zweiten Abschnitts 1660 V (= 36 * 46,1V) beträgt.

Sinkt die Stringspannung ausgehend von der Leerlaufspannung bei 1475 V ab, nimmt die Kennlinie einen unteren Verlauf 46, in dem alle Strings bis zu einer Spannung $U_{LL,5}$ von 1340 V in einem kurzen Zustand. Bei dieser Spannung und alle 10 V bei weiter fallender Spannung (siehe weitere Spannungssprünge $U_{LL,1...4}$) wird jeweils einer der Strings wieder in einen langen Zustand überführt, so dass sich fünf positive Spannungsstufen ergeben, bis die Kennlinie bei einer Spannung von 1300 V wieder am oberen Verlauf 45 angelangt ist.

Die Lage der Spannungsstufen muss hierbei nicht äquidistant ausgelegt, nicht einmal fest vorgegeben sein. In einer Ausführungsform ermittelt jeder String innerhalb seiner Schaltung zur Spannungsbegrenzung die eigenen Schwellwerte unabhängig von den anderen Strings, zum Beispiel auf der Grundlage des vorstehend beschriebenen Verfahrens. Es ist aber von Vorteil, wenn der Spannungsbereich 48, in dem die Strings sukzessive in den kurzen Zustand versetzt werden, von dem Spannungsbereich 47 getrennt ist, in dem die Strings sukzessive wieder in den langen Zustand versetzt werden. Weiterhin vorteilhaft ist es, wenn alle ersten Schwellwerte $U_{UL,1..5}$ kleiner als die maximale zulässige Eingangsspannung eines angeschlossenen Wandlers, insbesondere eines Wechselrichters, gewählt werden. Ebenfalls vorteilhaft ist es, wenn alle zweiten Schwellwerte $U_{LL,1..5}$ größer als die MPP Spannung bei den gegebenen Bedingungen gewählt werden, so dass sichergestellt ist, dass alle Strings sich in einem langen Zustand befinden, wenn das Photovoltaikfeld sich im MPP befindet. Hierdurch wird ein Leistungsverlust durch das erfindungsgemäße Verfahren beziehungsweise durch die erfindungsgemäße Schaltung zur Spannungsbegrenzung vermieden.

**Bezugszeichenliste**

| | |
|---|---|
| 1 | Schaltung |
| 2 | Photovoltaikfeld |
| 10 | Steuerung |
| 11 | Trennschalter |
| 12 | Überbrückungsschalter |
| 13 | Anschluss |
| 14 | Anschluss |
| 15 | Anschluss |
| 16 | Spannungseingang |
| 17 | Spannungseingang |
| 18 | Spannungseingang |
| 20 | String |
| 21 | Abschnitt |
| 22 | Abschnitt |
| 23 | Abschnitt |
| 24 | Solarmodul |
| 30-43 | Schritt |
| 45 | Verlauf |
| 46 | Verlauf |
| 47, 48 | Spannungsbereich |

**Patentansprüche**

1. Schaltung (1) zur Spannungsbegrenzung eines photovoltaischen Strings (20), der in einen ersten Abschnitt (21) und einen zweiten Abschnitt (22) einer Reihenschaltung von Solarmodulen (24) aufgeteilt ist, umfassend:

- einen ersten Anschluss (13) zur Verbindung mit einem ersten Ende des ersten Abschnitts (21), einen zweiten Anschluss (14) zur Verbindung mit einem ersten Ende des zweiten Abschnitts (22) und einem dritten Anschluss (15) zur Verbindung mit einem zweiten Ende des zweiten Abschnitts,
- einen Überbrückungsschalter (12), der mit einem Ende mit dem ersten Anschluss (13) und dem anderen Ende mit dem dritten Anschluss (15) verbunden ist und
- einen einem Trennschalter (11), der mit einem Ende mit dem ersten Anschluss (13) und dem anderen Ende mit dem zweiten Anschluss (14) verbunden ist, und
- einer Steuerung (10) zur Ansteuerung des Überbrückungsschalters (12) und des Trennschalters (11), **dadurch gekennzeichnet, dass**

die Steuerung (10) dazu eingerichtet ist, einen ersten Schwellwert $U_{UL}$ und einen zweiten, kleineren Schwellwert $U_{LL}$ in Abhängigkeit von einer über den Trennschalter (11) in einem geöffneten Zustand abfallenden Schalterspannung Uoc und unter Berücksichtigung der Anzahl der Solarmodule im ersten Abschnitt (21) und im zweiten Abschnitt (22) zu ermitteln, und eine zwischen dem ersten Anschluss (13) und einem Spannungseingang (16) der Schaltung (1) abfallenden Modulspannung Us mit den Schwellwerten $U_{UL}$, $U_{LL}$ zu vergleichen, um bei Überschreiten des ersten Schwellwertes $U_{UL}$ durch die Modulspannung Us den Trennschalter (11) zu öffnen und den Überbrückungsschalter (12) zu schließen, und bei Unterschreiten des zweiten Schwellwertes $U_{LL}$ durch die Spannung Us den Überbrückungsschalter (12) zu öffnen und den Trennschalter (11) zu schließen.

2. Schaltung (1) nach Anspruch 1, wobei die Schaltung zur Energieversorgung aus der Modulspannung Us eingerichtet ist.

3. Schaltung (1) nach Anspruch 1 oder 2, wobei in der Steuerung (10) eine Bedingung vorgesehen ist, bei deren Erfüllung im Fall, dass der Trennschalter (11) geschlossen ist, die Steuerung eine Kalibrierung der Schwellwerte

$U_{UL}$, $U_{LL}$ durchführt, indem der Trennschalter (11) kurzzeitig geöffnet, die über den geöffneten Trennschalter (11) abfallende Schalterspannung Uoc bestimmt wird, und hieraus aktualisierte Schwellwerte $U_{UL}$, $U_{LL}$ ermittelt werden.

4. Schaltung (1) nach einem der vorangehenden Ansprüche, wobei die Bedingung einen Ablauf einer vorgegebenen Zeitdauer seit dem letzten Schließen des Trennschalters (11) aufweist.

5. Schaltung (1) nach einem der vorangehenden Ansprüche, wobei die Bedingung eine Überschreitung eines vorgegebenen Änderungsschwellwertes durch die Differenz der Modulspannung Us zwischen dem aktuellen Wert und dem nach dem letzten Schließen des Trennschalters (11) bestimmten Wert aufweist.

6. Photovoltaikfeld (2) mit einer Mehrzahl von zwischen einem ersten und einem zweiten Gleichspannungsbus parallel geschalteten Strings (20), die jeweils einen ersten Abschnitt (21) und einen zweiten Abschnitt (22) von Reihenschaltungen von Solarmodulen (24) aufweisen, wobei die Abschnitte (21, 22) über eine Schaltung (1) nach einem der vorangehenden Ansprüche miteinander verbunden sind, wobei jeweils ein Ende des ersten Abschnitts (21) mit dem ersten Gleichspannungsbus und das andere Ende des ersten Abschnitts (21) mit dem ersten Anschluss (13) der Schaltung (1) verbunden sind, wobei ein Ende des zweiten Abschnitts (22) mit dem zweiten Anschluss (14) verbunden und das andere Ende des zweiten Abschnitts (22) mit dem zweiten Gleichspannungsbus und dem dritten Anschluss (15) der Schaltung (1) verbunden sind, und wobei der Spannungseingang (16) mit einem dem ersten Anschluss (13) der Schaltung (1) abgewandten Anschluss eines Solarmoduls (24) des ersten Abschnitts (21) verbunden ist.

7. Photovoltaikfeld (2) nach Anspruch 6, wobei der Spannungseingang (16) mit dem Anschluss desjenigen Solarmoduls (24) des ersten Abschnitts (21) verbunden ist, das mit dem anderen Anschluss direkt mit dem ersten Anschluss (13) der Schaltung (1) verbunden ist.

8. Photovoltaikfeld (2) nach einem der Ansprüche 6 bis 7, wobei die Anzahl der Solarmodule des ersten Abschnitts (21) derart gewählt ist, dass bei einer niedrigsten spezifizierten Umgebungstemperatur und einer höchsten spezifizierten Einstrahlung deren Leerlaufspannung noch unter einem vorgegebenen Maximalwert verbleibt, und die Anzahl der Solarmodule des zweiten Abschnitts (22) derart gewählt ist, dass bei der niedrigsten spezifizierten Umgebungstemperatur eine MPP-Spannung der Reihenschaltung des ersten und zweiten Abschnitts (21, 22) noch unter dem vorgegebenen Maximalwert verbleibt.

9. Photovoltaikfeld (2) nach einem der Ansprüche 6 bis 8, wobei das andere Ende des zweiten Abschnitts (22) mit dem zweiten Gleichspannungsbus über einen dritten Abschnitt von Solarmodulen verbunden ist.

10. Photovoltaikfeld (2) nach einem der Ansprüche 6 bis 9, wobei in den Schaltungen (1) der parallelen Strings (20) jeweils ein voneinander unterschiedlicher Offset hinterlegt ist, der bewirkt, dass die Steuerungen (10) der Schaltungen (1) bei gleicher bestimmter Schalterspannung Uoc unterschiedliche Schwellwerte $U_{UL}$, $U_{LL}$ ermitteln.

11. Verfahren zur Spannungsbegrenzung eines photovoltaischen Strings (20), wobei der String (20) einen ersten Abschnitt (21) von Solarmodulen und einen zweiten Abschnitt (22) von Solarmodulen umfasst, wobei ein Überbrückungsschalter (12) parallel zum zweiten Abschnitt (22) angeordnet ist und ein Trennschalter (11) in Reihe zu den Solarmodulen des zweiten Abschnitts (22) angeordnet ist,
das Verfahren umfassend die Schritte:

- wiederholtes Bestimmen einer Modulspannung $U_S$ innerhalb des ersten Abschnitts (21) und einer über den Trennschalter (11) abfallenden Schalterspannung Uoc, während der Trennschalter (11) geöffnet und der Überbrückungsschalter (12) geschlossen ist,
- Bestimmen eines ersten Schwellwerts $U_{UL}$ und eines zweiten, kleineren Schwellwerts $U_{LL}$ in Abhängigkeit der Schalterspannung $U_{OC}$ und unter Berücksichtigung einer Anzahl der Solarmodule im ersten Abschnitt (21) und einer Anzahl der Solarmodule im zweiten Abschnitt (22),
- Schließen des Überbrückungsschalters (12) und Öffnen des Trennschalters (11) zur Herstellung eines kurzen Stringzustands, wenn die aktuell bestimmte Modulspannung $U_S$ den ersten Schwellwert $U_{UL}$ überschreitet, und Öffnen des Überbrückungsschalters (12) und Schließen des Trennschalters (11) zur Herstellung eines langen Stringzustands, wenn die aktuell bestimmte Modulspannung $U_S$ den zweiten Schwellwert $U_{LL}$ unterschreitet.

12. Verfahren nach Anspruch 11, wobei während des langen Stringzustands eine Bedingung zur Neukalibrierung geprüft wird, und wobei bei Erfüllung der Bedingung die Schalterstellung kurzzeitig in den kurzen Stringzustand wechselt, um die über den Trennschalter (11) abfallende Schalterspannung $U_{OC}$ zu bestimmen und daraus aktualisierte Schwellwerte $U_{UL}$, $U_{LL}$ zu ermitteln.

13. Verfahren nach Anspruch 12, wobei die Bedingung den Ablauf einer Wartezeit aufweist, in der der String in einem langen Stringzustand war, wobei die Wartezeit größer 100 Sekunden ist.

14. Verfahren nach einem der Ansprüche 12 bis 13, wobei die Bedingung eine Überschreitung eines vorgegebenen Änderungsschwellwertes durch die Differenz der Modulspannung $U_S$ zwischen dem aktuellen Wert und dem Wert direkt nach dem letzten Wechsel in den langen Stringzustand aufweist.

15. Verfahren nach einem der Ansprüche 11 bis 14, wobei jeweils zulässige Wertebereiche für den ersten Schwellwert $U_{UL}$ und den zweiten Schwellwert $U_{LL}$ vorgegeben werden, wobei beim Verlassen des jeweiligen zulässigen Wertebereichs der Schwellwert auf den jeweiligen Grenzwert des Wertebereichs festgelegt wird.

**Claims**

1. A circuit (1) for voltage limitation of a photovoltaic string (20) divided into a first section (21) and a second section (22) of a series connection of solar modules (24), comprising

   - a first terminal (13) for connection to a first end of the first section (21), a second terminal (14) for connection to a first end of the second section (22), and a third terminal (15) for connection to a second end of the second section,
   - a bypass switch (12) connected at one end to the first terminal (13) and at the other end to the third terminal (15), and
   - a isolating switch (11) connected at one end to the first terminal (13) and at the other end to the second terminal (14), and
   a controller (10) for controlling the bypass switch (12) and the isolating switch (11), **characterised in that** the controller (10) is adapted to determine a first threshold value $U_{UL}$ and a second, smaller threshold value $U_{LL}$ as a function of a switch voltage Uoc dropped across the isolating switch (11) in an open state and taking into account the number of solar modules in the first section (21) and in the second section (22), and to compare a module voltage $U_S$, dropped between the first terminal (13) and a voltage input (16) of the circuit (1), with the threshold values $U_{UL}$, $U_{LL}$ in order to open the isolating switch (11) and close the bypass switch (12) when the module voltage $U_S$ exceeds the first threshold value $U_{UL}$, and to open the bypass switch (12) and close the isolating switch (11) when the voltage $U_S$ falls below the second threshold value $U_{LL}$.

2. The circuit (1) according to claim 1, wherein the circuit is adapted to be power supplied by the module voltage $U_S$.

3. The circuit (1) according to claim 1 or 2, wherein a condition is provided in the controller (10), upon the fulfilment of which condition, in the event that the isolating switch (11) is closed, the controller carries out a calibration of the threshold values $U_{UL}$, $U_{LL}$ by briefly opening the isolating switch (11), determining the switch voltage $U_{OC}$ dropped across the open isolating switch (11), and determining updated threshold values $U_{UL}$, $U_{LL}$ therefrom.

4. The circuit (1) according to one of the preceding claims, the condition comprising elapsing of a predetermined time period since the last closing of the isolating switch (11).

5. The circuit (1) according to one of the preceding claims, wherein the condition comprises exceeding of a predetermined change threshold value by the difference of the module voltage $U_S$ between the actual value and the value determined after the last closing of the isolating switch (11).

6. A photovoltaic array (2) comprising a plurality of strings (20) connected in parallel between a first and a second DC bus, each string (20) comprising a first section (21) and a second section (22) of series connections of solar modules (24), said sections (21, 22) being connected to each other by a circuit (1) according to any of the preceding claims, wherein each of said first sections (21) is connected with one end to said first DC bus and with the other end of said first section (21) to the first terminal (13) of said circuit (1), wherein one end of the second section (22) is connected to the second terminal (14) and the other end of the second section (22) is connected to the second DC voltage bus and the third terminal (15) of the circuit (1), and wherein the voltage input (16) is connected to a terminal of a solar module (24) of the first section (21) which is remote from the first terminal (13) of the circuit (1).

7. The photovoltaic array (2) according to claim 6, wherein the voltage input (16) is connected to the terminal of that solar module (24) of the first section (21) which is directly connected with the other end to the first terminal (13) of the circuit (1).

8. The photovoltaic array (2) according to one of claims 6 to 7, wherein the number of solar modules of the first section (21) is selected such that at a lowest specified ambient temperature and a highest specified irradiation, the open-circuit voltage thereof still remains below a predetermined maximum value, and the number of solar modules of the second section (22) is selected such that at the lowest specified ambient temperature, an MPP voltage of the series connection of the first and second sections (21, 22) still remains below the predetermined maximum value.

9. The photovoltaic array (2) according to any one of claims 6 to 8, wherein the other end of the second section (22) is connected to the second DC bus via a third section of solar modules.

10. The photovoltaic array (2) according to one of claims 6 to 9, wherein in the circuits (1) of the parallel strings (20) in each case a mutually different offset is provided, which causes the controllers (10) of the circuits (1) to determine different threshold values $U_{UL}$, $U_{LL}$ for the same specific switch voltage $U_{OC}$.

11. A method for voltage limitation of a photovoltaic string (20), wherein the string (20) comprises a first section (21) of solar modules and a second section (22) of solar modules, wherein a bypass switch (12) is arranged in parallel with the second section (22) and an isolating switch (11) is arranged in series with the solar modules of the second section (22),
the method comprising the steps of:

- repeatedly determining a module voltage Us within the first section (21) and a switch voltage $U_{OC}$ dropped across the isolating switch (11) while the isolating switch (11) is open and the bypass switch (12) is closed,
- determining a first threshold value $U_{UL}$ and a second, smaller threshold value $U_{LL}$ as a function of the switch voltage $U_{OC}$ and taking into account a number of solar modules in the first section (21) and a number of solar modules in the second section (22),
- closing the bypass switch (12) and opening the isolating switch (11) to produce a short string state when the currently determined module voltage $U_S$ exceeds the first threshold value $U_{UL}$, and opening of the bypass switch (12) and closing of the isolating switch (11) to produce a long string state when the currently determined module voltage $U_S$ falls below the second threshold value $U_{LL}$.

12. The method according to claim 11, wherein a condition for recalibration is tested during the long string state, and wherein, when the condition is fulfilled, the switch position changes briefly to the short string state in order to determine the switch voltage $U_{OC}$ dropped across the isolating switch (11) and to determine updated threshold values $U_{UL}$, $U_{LL}$ therefrom.

13. The method according to claim 12, wherein the condition comprises elapsing of a waiting time in which the string is in a long string state, the waiting time being greater than 100 seconds.

14. The method according to any one of claims 12 to 13, wherein the condition comprises exceeding a predetermined change threshold value by the difference in module voltage $U_S$ between the current value and the value immediately after the last change to the long string state.

15. The method according to one of claims 11 to 14, wherein respectively permissible value ranges are specified for the first threshold value $U_{UL}$ and the second threshold value $U_{LL}$, wherein for a threshold value outside of the respective permissible value range the threshold value is fixed to the respective limit value of the value range.

**Revendications**

1. Circuit électronique (1) pour la limitation de tension d'un string photovoltaïque (20) divisé en une première partie (21) et une deuxième partie (22) d'une connexion en série de panneaux photovoltaïques (24), comprenant :

- une première borne (13) pour la connexion à une première extrémité de la première section (21), une deuxième borne (14) pour la connexion à une première extrémité de la deuxième section (22), et une troisième borne (15) pour la connexion à une deuxième extrémité de la deuxième section,

- un relais de pontage (12) connecté à une extrémité à la première borne (13) et à l'autre extrémité à la troisième borne (15), et

- un sectionneur (11) connecté à une extrémité à la première borne (13) et à l'autre extrémité à la deuxième borne (14), et

une commande (10) pour commander le relais de pontage (12) et le sectionneur (11), **caractérisé en ce que** la commande (10) est configurée pour déterminer une première valeur limite $U_{UL}$ et une deuxième valeur limite $U_{LL}$, plus petite, en fonction d'une tension de commutation $U_{OC}$ qui chute par l'intermédiaire du sectionneur (11) à l'état ouvert et en tenant compte du nombre de panneaux photovoltaïques dans la première section (21) et dans la deuxième section (22), et de comparer une tension de panneaux photovoltaïques $U_S$, qui chute entre la première borne (13) et une entrée de tension (16) du circuit (1), avec les valeurs limites $U_{UL}$, $U_{LL}$ afin d'ouvrir le sectionneur (11) et de fermer le relais de pontage (12) lorsque la tension de panneaux photovoltaïques Us dépasse la première valeur limite $U_{UL}$, et d'ouvrir le relais de pontage (12) et de fermer le sectionneur (11) lorsque la tension Us tombe en dessous de la deuxième valeur limite $U_{LL}$.

2. Circuit électronique (1) selon la revendication 1, dans lequel le circuit électronique est configuré pour une alimentation électrique à partir de la tension de panneaux photovoltaïques $U_S$.

3. Circuit électronique (1) selon la revendication 1 ou 2, dans lequel une condition est prévue dans la commande (10), à la réalisation de laquelle condition, dans le cas où le sectionneur (11) est fermé, la commande effectue un calibrage des valeurs limites $U_{UL}$, $U_{LL}$ en ouvrant brièvement le sectionneur (11), en déterminant la tension de commutation $U_{OC}$ chutant aux bornes du sectionneur (11) ouvert, et en déterminant les valeurs limites $U_{UL}$, $U_{LL}$ actualisées à partir de celles-ci.

4. Circuit électronique (1) selon l'une des revendications précédentes, la condition ayant un écoulement d'une période de temps prédéterminée depuis la dernière fermeture du sectionneur (11).

5. Circuit électronique (1) selon l'une des revendications précédentes, dans lequel la condition présente un dépassement d'une valeur limite de changement prédéterminée par la différence de la tension de panneaux photovoltaïques $U_S$ entre la valeur actuelle et la valeur déterminée après la dernière fermeture du sectionneur (11).

6. Champ photovoltaïque (2) comprenant une pluralité de strings (20) connectés en parallèle entre un premier et un second bus à courant continu, chaque string (20) comprenant une première partie (21) et une seconde partie (22) de circuits en série de panneaux photovoltaïques (24), lesdites parties (21, 22) étant connectées ensemble par un circuit (1) selon l'une des revendications précédentes, dans lequel une extrémité de ladite première partie (21) est connectée audit premier bus à courant continu et l'autre extrémité de ladite première partie (21) est connectée à la première borne (13) dudit circuit (1), dans lequel une extrémité de la deuxième section (22) est connectée à la deuxième borne (14) et l'autre extrémité de la deuxième section (22) est connectée au deuxième bus DC et à la troisième borne (15) du circuit électronique (1), et dans lequel l'entrée de tension (16) est connectée à une borne d'un panneau photovoltaïque (24) de la première section (21) qui est éloignée de la première borne (13) du circuit électronique (1).

7. Champ photovoltaïque (2) selon la revendication 6, dans lequel l'entrée de tension (16) est reliée à la borne du panneau photovoltaïque (24) de la première section (21) qui est reliée par l'autre borne directement à la première borne (13) du circuit électronique (1).

8. Champ photovoltaïque (2) selon l'une des revendications 6 à 7, dans lequel le nombre de panneaux photovoltaïques de la première section (21) est choisi de telle sorte qu'à une température ambiante spécifiée la plus basse et à un rayonnement solaire spécifié le plus élevé, leur tension à vide reste encore en dessous d'une valeur maximale prédéterminée, et le nombre de panneaux photovoltaïques de la deuxième section (22) est choisi de telle sorte qu'à la température ambiante spécifiée la plus basse, une tension MPP du montage en série des première et deuxième sections (21, 22) reste encore en dessous de la valeur maximale prédéterminée.

9. Champ photovoltaïque (2) selon l'une des revendications 6 à 8, dans lequel l'autre extrémité de la deuxième section (22) est connectée au deuxième bus de courant continu via une troisième section de panneaux photovoltaïques.

10. Champ photovoltaïque (2) selon l'une des revendications 6 à 9, dans lequel dans les circuits électroniques (1) des strings parallèles (20) est déposé à chaque fois un décalage mutuellement différent, ce qui a pour effet que les commandes (10) des circuits électroniques (1) déterminent différentes valeurs limites $U_{UL}$, $U_{LL}$ pour la même tension de commutation spécifique $U_{OC}$.

11. Méthode de limitation de la tension d'un string photovoltaïque (20), le string (20) comprenant une première section (21) de panneaux photovoltaïques et une deuxième section (22) de panneaux photovoltaïques, un relais de pontage (12) étant disposé en parallèle avec la deuxième section (22) et un sectionneur (11) étant disposé en série avec les panneaux photovoltaïques de la deuxième section (22) la procédure comprenant les étapes :

- détermination répétée d'une tension de panneaux photovoltaïques Us dans la première section (21) et d'une tension du sectionneur $U_{OC}$ tombée aux bornes du sectionneur (11) alors que le sectionneur (11) est ouvert et que le relais de pontage (12) est fermé
- déterminer une première valeur limite $U_{UL}$ et une deuxième valeur limite $U_{LL}$, plus petite, en fonction de la tension de commutation $U_{OC}$ et en tenant compte d'un nombre de panneaux photovoltaïques dans la première section (21) et d'un nombre de panneaux photovoltaïques dans la deuxième section (22),
- Fermeture du relais de pontage (12) et ouverture du sectionneur (11) pour produire un état à chaîne courte des panneaux photovoltaïques lorsque la tension de panneaux photovoltaïques $U_S$ actuellement déterminée dépasse la première valeur limite $U_{UL}$, et ouverture du relais de pontage (12) et fermeture du sectionneur (11) pour produire un état à chaîne longue des panneaux photovoltaïques lorsque la tension de panneaux photovoltaïques $U_S$ actuellement déterminée tombe en dessous de la deuxième valeur limite $U_{LL}$.

12. Méthode selon la revendication 11, dans laquelle, pendant l'état à chaîne longue des panneaux photovoltaïques, une condition de recalibrage est vérifiée, et dans laquelle, lorsque la condition est remplie, la position du commutateur passe brièvement à l'état à chaîne courte des panneaux photovoltaïques afin de déterminer la tension de commutation $U_{OC}$ chutant aux bornes du sectionneur (11) et de déterminer à partir de là des valeurs limites actualisées $U_{UL}$, $U_{LL}$.

13. Méthode selon la revendication 12, dans laquelle la condition comprend l'écoulement d'un temps d'attente pendant lequel le string était dans un état à chaîne longue des panneaux photovoltaïques, le temps d'attente étant supérieur à 100 secondes.

14. Méthode selon l'une des revendications 12 à 13, dans laquelle la condition comprend le dépassement d'une valeur limite de changement prédéterminée par la différence de tension de panneaux photovoltaïques $U_S$ entre la valeur actuelle et la valeur immédiatement après le dernier changement de l'état à chaîne longue des panneaux photovoltaïques.

15. Méthode selon l'une des revendications 11 à 14, dans laquelle des plages de valeurs respectivement admissibles sont spécifiées pour la première valeur limite $U_{UL}$ et la deuxième valeur limite $U_{LL}$, la valeur limite étant fixée à la valeur limite respective de la plage de valeurs lorsqu'on quitte la plage de valeurs respectivement admissible.

Fig. 1

EP 3 560 099 B1

**Fig. 2**

EP 3 560 099 B1

Fig. 2a

**Fig. 3**

START

30 — Langer String

31 — Bedingung Neukalibrierung erfüllt?

40 — Kurzer String
41 — $U_{OC}$ bestimmen
42 — $U_{UL}$, $U_{LL}$ bestimmen
43 — Langer String

32 — $U_S$ bestimmen

33 — $U_S < U_{UL}$?

34 — Kurzer String
35 — $U_{OC}$ bestimmen
36 — $U_{UL}$, $U_{LL}$ bestimmen
37 — $U_S$ bestimmen
38 — $U_S < U_{LL}$?

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20130049710 A1
- EP 2362520 A1

- DE 102010009120 A1